Europäisches Patentamt

European Patent Office

Office européen des brevets

(19)

(11) EP 0 923 141 A1

(12) DEMANDE DE BREVET EUROPEEN

(43) Date de publication:
16.06.1999 Bulletin 1999/24

(51) Int Cl.6: H01L 31/0232, H01L 31/052

(21) Numéro de dépôt: 98402972.8

(22) Date de dépôt: 27.11.1998

(84) Etats contractants désignés:
AT BE CH CY DE DK ES FI FR GB GR IE IT LI LU
MC NL PT SE
Etats d'extension désignés:
AL LT LV MK RO SI

(30) Priorité: 01.12.1997 FR 9715082

(71) Demandeur: COMMISSARIAT A L'ENERGIE
ATOMIQUE
75015 Paris (FR)

(72) Inventeurs:
• Marion, Francois
38120 Saint Egreve (FR)
• Agnese, Patrick
38340 Voreppe (FR)

(74) Mandataire: Dubois-Chabert, Guy
c/o BREVATOME
25, rue de Ponthieu
75008 Paris (FR)

(54) Dispositif de photodétection, procédé de fabrication de ce dispositif et application à la détection multispectrale.

(57) Ce dispositif comprend au moins un élément comportant une couche (18) d'absorption d'un rayonnement et une couche (22) de réflexion du rayonnement non absorbé. La couche absorbante crée un premier déphasage du rayonnement réfléchi par rapport au rayonnement incident. Selon l'invention, on prévoit entre la couche absorbante et la couche réflectrice une couche (24) créant un deuxième déphasage qui compense le premier pour obtenir une réponse spectrale sensiblement plate de la part du dispositif.

FIG. 6

EP 0 923 141 A1

# Description

## DOMAINE TECHNIQUE

La présente invention concerne un dispositif de photodétection.

Elle s'applique notamment à la détection multispectrale.

L'invention concerne aussi un procédé de fabrication du dispositif de photodétection.

L'invention permet de réaliser aussi bien un détecteur par photoconduction qu'un détecteur photovoltaïque.

## ÉTAT DE LA TECHNIQUE ANTÉRIEURE

Les techniques de détection par photoconduction et les techniques de détection photovoltaïque peuvent conduire à former des couches minces semi-conductrices permettant l'absorption de photons et la génération de paires électron-trou par transition bande à bande (transition intrinsèque) ou par transition intra-bande (transition extrinsèque).

Dans le cas d'une couche mince, le rayonnement incident est absorbé sur une faible épaisseur.

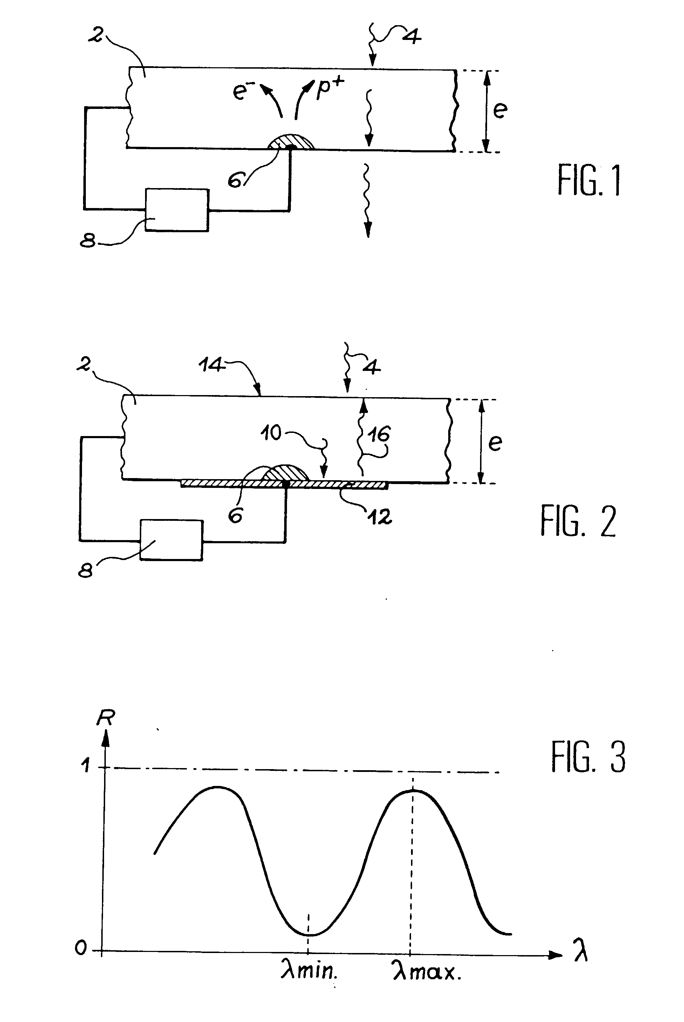

Un exemple de détecteur photovoltaïque est schématiquement représenté en coupe transversale sur la figure 1.

Ce détecteur comprend une couche semi-conductrice mince 2 dont l'épaisseur est noté e et qui reçoit le rayonnement incident 4 que l'on veut détecter.

De plus on a créé dans la couche 2 une jonction PN.

A cet effet, la couche 2 est par exemple de type P et l'on a formé dans cette couche une zone 6 de type N.

Lorsque le rayonnement incident 4 est absorbé par la couche 2 qui constitue une couche détectrice ou couche active, des paires électron-trou e⁻-p⁺ sont créées dans cette couche 2 et l'on collecte les charges résultantes dans la zone de charge d'espace de la jonction PN.

On voit sur la figure 1 un dispositif 8 de détection du courant électrique ainsi engendré.

Ce dispositif 8 relie la zone de type P à la zone de type N du détecteur.

Pour des considérations de limitation de bruit ou de facilité de fabrication on peut être conduit à réduire au maximum l'épaisseur e de la couche détectrice 2.

Cependant pour récupérer un maximum de photons incidents on est alors amené à disposer sur cette couche mince 2, du côté de la zone dopée N, une couche réflectrice destinée à réfléchir le rayonnement 10 qui n'a pas été absorbé par la couche 2.

On obtient ainsi un détecteur du genre de celui qui est représenté schématiquement en coupe transversale sur la figure 2.

On voit sur cette figure 2 la couche réflectrice 12 formée sur la face de la couche 2 du côté de laquelle se trouve la zone 6 de type N.

Ainsi les photons ayant traversés la couche mince 2 sans être absorbés par celle-ci sont réfléchis vers la face d'entrée 14 de celle-ci (face par où pénètre le rayonnement incident 4) par la couche 12 qui les réinjecte ainsi dans la couche 2.

Le rendement quantique du détecteur de la figure 2 (qui est le nombre de porteurs engendrés divisé par le nombre de photons incidents) est ainsi supérieur à celui du détecteur de la figure 1.

Si l'on diminue suffisamment l'épaisseur e de la couche 2 il peut même exister des photons non absorbés qui atteignent la face d'entrée 14 du détecteur de la figure 2.

Dès lors qu'une partie des photons n'est pas absorbée dans un trajet de longueur 2e il se produit un phénomène classique d'interférence au niveau de la face d'entrée 14, entre le rayonnement entrant 4 et le rayonnement sortant 16.

Étant donné que l'on cherche à obtenir une absorption maximale de lumière par la couche 2, on fait en sorte qu'il y ait un minimum de réflexion en la face d'entrée 14.

Il existe alors une longueur d'onde $\lambda$min telle que :

$$2n.e = (2k+1)\lambda min/2.$$

Dans cette égalité n représente l'indice de réfraction de la couche 2 et k est un nombre entier relatif.

Un rayonnement ayant la longueur d'onde $\lambda$min crée ainsi un minimum de réflexion en la face d'entrée 14 du détecteur de la figure 2.

Dès que la longueur d'onde du rayonnement incident s'éloigne de cette longueur d'onde $\lambda$min, la réflexion augmente en la face d'entrée 14 du détecteur.

Pour certaines longueurs d'onde $\lambda$max, on peut même avoir un maximum de réflexion au lieu d'un minimum en cette face d'entrée.

On obtient un tel maximum de réflexion lorsque l'égalité suivante est vérifiée :

$$2n.e = k.\lambda max.$$

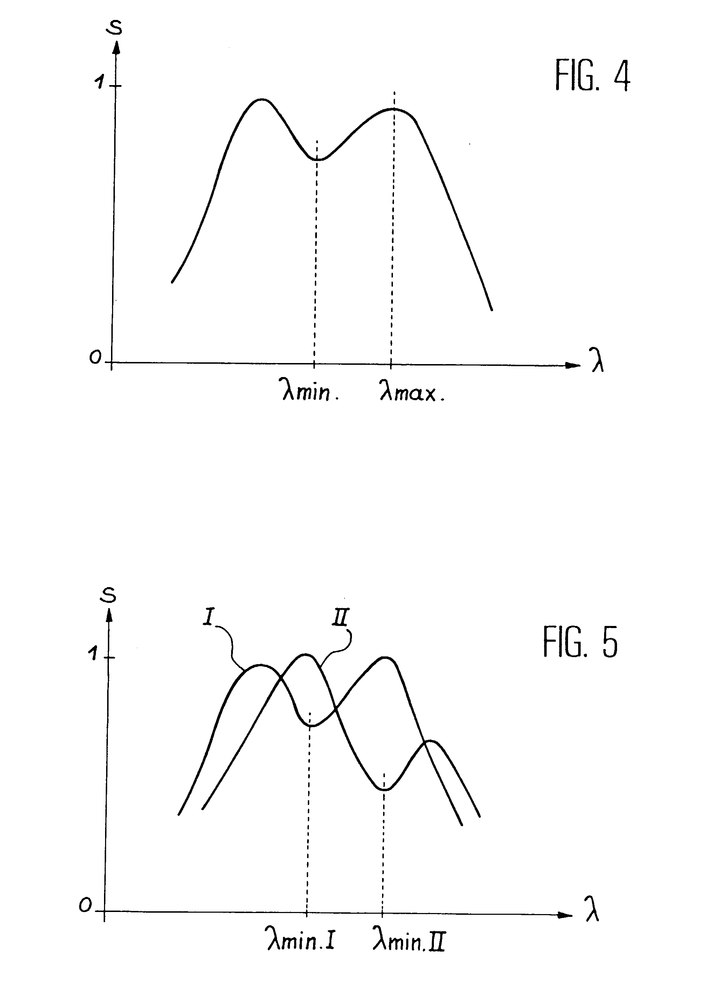

On a représenté sur la figure 3 les variations du rapport R de l'intensité du rayonnement optiquement réfléchi à l'intensité du rayonnement incident en fonction de la longueur d'onde $\lambda$.

Cette figure 3 illustre la possibilité d'obtenir, pour la longueur d'onde $\lambda$min, un minimum de rayonnement réfléchi au niveau de la face d'entrée 14 et, pour une autre longueur d'onde $\lambda$max, un maximum de rayonnement réfléchi au niveau de cette face d'entrée.

La réponse spectrale d'un détecteur du genre de celui de la figure 2 peut alors se présenter sous la forme qui est représentée sur la figure 4.

Cette figure 4 montre les variations de la réponse spectrale normalisée S du détecteur en fonction de la longueur d'onde λ.

Cette réponse spectrale S est le produit de l'absorption « optique » par la réponse « électrique » du détecteur.

L'un des problèmes que pose un détecteur du genre de celui de la figure 2 est que, dans certains cas, l'épaisseur e de la couche 2 ne peut être parfaitement maîtrisée et que, par conséquent, plusieurs détecteurs ayant des épaisseurs e différentes (toutes choses égales par ailleurs) présentent des longueurs d'onde λmin et λmax différentes.

Ceci est schématiquement illustré par la figure 5 où l'on voit la réponse spectrale S normalisée en fonction de la longueur d'onde λ pour un premier détecteur (courbe I) et pour une deuxième détecteur (courbe II) dont les couches absorbantes n'ont pas la même épaisseur.

On voit bien par exemple sur la figure 5 que la longueur d'onde λminI correspondant à un minimum de réflexion en la face d'entrée du premier détecteur est différente de la longueur d'onde λminII correspondant à un minimum de réflexion en la face d'entrée du deuxième détecteur.

Ce problème peut être important dans le cas de détecteurs matriciels c'est-à-dire de détecteurs qui sont construits les uns à côté des autres sur une même couche absorbante et forment une matrice sur celle-ci.

Dans ce cas, il existe des détecteurs ou pixels de détection n'ayant pas la même réponse spectrale que leurs voisins si l'épaisseur e de la couche absorbante n'est pas constante sur l'ensemble de la matrice.

## EXPOSÉ DE L'INVENTION

La présente invention a pour but de remédier aux inconvénients précédents.

Elle a pour objet un dispositif de photodétection comprenant au moins un élément de photodétection qui comprend :

- une couche absorbante apte à absorber une partie d'un rayonnement incident, tombant sur une première face de cette couche absorbante, et
- une couche réflectrice qui est placée en regard d'une deuxième face de cette couche absorbante et qui est apte à réfléchir une partie de ce rayonnement n'ayant pas été absorbée par la couche absorbante, cette couche absorbante créant un premier déphasage du rayonnement ainsi réfléchi par rapport au rayonnement incident,

ce dispositif étant caractérisé en ce qu'il comprend en outre une couche de déphasage qui est comprise entre la couche réflectrice et au moins une partie de la couche absorbante et qui est apte à créer un deuxième déphasage du rayonnement réfléchi par la couche réflectrice par rapport au rayonnement incident, l'épaisseur de la couche de déphasage étant choisie de façon que les premier et deuxième déphasages se compensent pour obtenir une réponse spectrale sensiblement plate de la part du dispositif dans un intervalle de longueurs d'onde déterminé.

De préférence, l'indice de réfraction du matériau constitutif de la couche de déphasage est voisin de l'indice de réfraction du matériau constitutif de la couche absorbante.

Selon un mode de réalisation préféré du dispositif objet de l'invention, la couche absorbante et la couche de déphasage sont faites du même matériau.

Selon un premier mode de réalisation particulier, le deuxième déphasage est discret et la couche de déphasage recouvre la moitié de la deuxième face de la couche absorbante.

Dans ce cas, la couche de déphasage peut recouvrir une partie une partie périphérique de la deuxième face de la couche absorbante, la partie ainsi recouverte ayant la même aire que la partie non recouverte de cette deuxième face.

Selon un deuxième mode de réalisation particulier, le deuxième déphasage est continu et graduel d'un côté à l'autre de la deuxième face de la couche absorbante.

Le dispositif objet de l'invention peut comprendre plusieurs exemplaires dudit élément de photodétection, organisés en matrice.

Un dispositif conforme à l'invention peut comprendre plusieurs exemplaires dudit élément de photodétection alternant avec d'autres éléments de photodétection comprenant chacun seulement ladite couche absorbante et ladite couche réflectrice, de manière à former un détecteur multispectral.

On peut aussi obtenir un détecteur multispectral en prévoyant plusieurs exemplaires dudit élément de photodétection formant une pluralité de groupes d'éléments de photodétection, l'épaisseur de la couche de déphasage étant la même pour tous les éléments d'un même groupe mais différente d'un groupe à l'autre, de manière à former un détecteur multispectral.

La présente invention concerne aussi un procédé de fabrication du dispositif de photodétection objet de l'invention, ce procédé étant caractérisé en ce qu'on forme d'abord la couche absorbante et ensuite, pour chaque élément de photodétection, la couche de déphasage puis la couche réflectrice.

Selon un premier mode de mise en euvre particulier du procédé objet de l'invention, une couche de déphasage est formée sur la couche absorbante puis gravée pour chaque élément de photodétection.

Selon un deuxième mode de mise en oeuvre particulier, la couche de déphasage est formée par gravure de la couche absorbante.

## BRÈVE DESCRIPTION DES DESSINS

La présente invention sera mieux comprise à la lecture de la description d'exemples de réalisation donnés ci-après, à titre purement indicatif et nullement limitatif, en faisant référence aux dessins annexés sur lesquels :

- la figure 1 illustre schématiquement un photodétecteur connu, sans couche réflectrice, et a déjà été décrite,
- la figure 2 illustre schématiquement un photodétecteur connu, avec couche réflectrice, et a déjà été décrite,
- la figure 3 représente le spectre de réflexion d'une couche mince absorbante, du genre de celle que comprend le détecteur de la figure 2 et en la face d'entrée de laquelle ont lieu des interférences, et a déjà été décrite,
- la figure 4 représente la réponse spectrale normalisée d'un détecteur du genre de celui de la figure 2 et a déjà été décrite,
- la figure 5 représente les réponses spectrales respectives de deux photodétecteurs n'ayant pas la même épaisseur de couche active, et a déjà été décrite,
- la figure 6 est une vue en coupe transversale schématique d'un mode de réalisation particulier du dispositif objet de l'invention,
- la figure 7 est la coupe I-I de la figure 6,
- la figure 8 représente la réponse spectrale du dispositif des figures 6 et 7,
- la figure 9 est une vue en coupe transversale schématique d'un autre mode de réalisation particulier du dispositif objet de l'invention,
- la figure 10 représente les réponses spectrales respectives de deux photodétecteurs n'ayant pas la même épaisseur de couche absorbante ni la même longueur d'onde de coupure,
- la figure 11 représente les réponses spectrales respectives de ces deux photodétecteurs munis de couches de déphasage conformément à l'invention,
- la figure 12 représente la réponse spectrale obtenue par simulation d'un détecteur conforme à l'invention,
- la figure 13A à 13D illustrent schématiquement des étapes d'un procédé conforme à l'invention, et
- la figure 14 illustre schématiquement des détecteurs multispectraux conformes à l'invention.

## EXPOSÉ DÉTAILLÉ DE MODES DE RÉALISATION PARTICULIERS

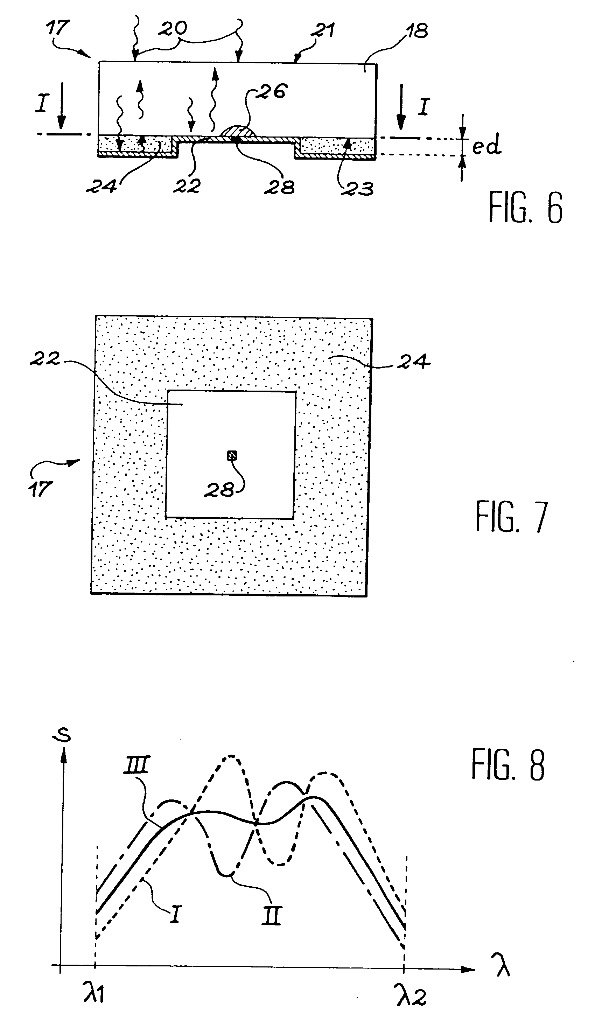

La figure 6 est une vue en coupe transversale schématique d'un dispositif conforme à l'invention.

Dans l'exemple représenté il s'agit d'un dispositif photovoltaïque comprenant un ou plusieurs éléments de photodétection tels que l'élément 17, cet élément 17 comprenant :

- une couche 17 mince absorbante 18 faite d'un matériau semi-conducteur par exemple de type P qui est apte à absorber une partie d'un rayonnement 20 tombant sur une première face 21 ou face-avant de cette couche 18, et
- une couche réflectrice 22 qui est placée en regard d'une deuxième face 23 ou face-arrière de la couche 18 et qui est apte à réfléchir une partie de ce rayonnement n'ayant pas été absorbée par la couche 18.

Conformément à l'invention, l'élément de photodétection 17 comprend en outre une autre couche 24 appelée couche de déphasage, dont l'épaisseur est notée ed et dont l'indice de réfraction est noté nd.

Cette couche 24 est comprise entre les couches 18 et 22 et, dans l'exemple représenté, cette couche 24 ne recouvre que la moitié de la deuxième face 23 de la couche 18.

La figure 7 est la coupe I-I de la figure 6 c'est-à-dire une vue en coupe de la figure 6, dont le plan de coupe contient l'interface des couches 18 et 24.

On voit que la couche 24 recouvre une partie périphérique de la deuxième face 23 de la couche absorbante 18.

La partie ainsi recouverte a la même aire que la partie non recouverte de cette deuxième face.

On voit aussi sur la figure 6 la zone 26 de type N que comprend l'élément de détection photovoltaïque du côté de la face 23 de la couche 18 ainsi qu'un contact électrique 28 permettant la connexion de cette zone 26 à un dispositif extérieur lors de l'utilisation de l'élément 17.

D'une manière générale, l'épaisseur ed de la couche 24 dépend du type de détection et de la gamme de longueurs d'onde considérés.

Dans l'exemple considéré rappelons qu'il s'agit d'une détection photovoltaïque.

Plus précisément, l'épaisseur de la couche 24 est choisie de telle manière que le chemin optique parcouru par le rayonnement, entre le moment où il pénètre dans la couche 24 et le moment où il en ressort, après réflexion par la couche 22, vérifie l'égalité suivante :

$$2nd.ed = (2k+1)\lambda c/2$$

dans laquelle k est un nombre entier relatif et $\lambda c$ représente le centre du domaine spectral (centre de la gamme de longueurs d'onde) considéré.

On peut par exemple choisir k=0, la couche 24 constituant alors une sorte de couche « quart d'onde ».

De préférence cette couche 24 est faite d'un matériau dont l'indice de réfraction est proche de celui du matériau constitutif de la couche 18.

On peut même utiliser le même matériau pour les couches 18 et 24.

En effet on cherche bien entendu à minimiser les réflexions à l'interface entre les couches 18 et 24.

La figure 8 montre les variations de la réponse spectrale normalisée S en fonction de la longueur d'onde $\lambda$ pour un dispositif du genre de celui des figures 6 et 7.

Le domaine spectral considéré est délimité par deux longueurs d'onde $\lambda 1$ et $\lambda 2$.

Dans le secteur spatial ne comportant pas la couche de déphasage 24, la réponse spectrale correspond à la courbe I.

Dans le secteur spatial comportant la couche 24, la réponse spectrale correspond à la courbe II.

On voit que dans ce deuxième secteur spatial l'onde électromagnétique de retour est déphasée de $\lambda c/2$ par rapport à celle de la courbe I.

De ce fait les minimums de la courbe II sont là où se trouvent les maximums de la courbe I.

La réponse globale de l'élément de photodétection ou pixel 17 correspond à la somme des photons absorbés dans le secteur spatial ne comportant pas la couche 24 et des photons absorbés dans le secteur spatial comportant la couche 24.

Cette réponse globale est représentée par la somme des réponses spectrales correspondant aux deux secteurs.

Les variations de cette somme en fonction de la longueur d'onde sont représentés par la courbe III.

Cette courbe III constitue la moyenne des courbes I et II.

On voit que la réponse spectrale résultante de l'élément de photodétection 1 est sensiblement plate dans le domaine spectral considéré [$\lambda 1$, $\lambda 2$].

En effet le signal de sortie de cet élément de photodétection 17 est proportionnel au nombre de porteurs engendrés dans l'ensemble de cet élément et donc à la somme des porteurs engendrés dans le secteur sans couche de déphasage et des porteurs engendrés dans le secteur avec couche de déphasage.

Quelle que soit l'épaisseur e de la couche absorbante 18, la réponse spectrale résultante est la somme de deux réponses spectrales complémentaires, l'une ayant des maximums en des longueurs d'onde qui correspondent aux minimums de l'autre et réciproquement.

Le résultat est bien une réponse spectrale sensiblement plate dans une gamme de longueurs d'onde qui peut être large.

En pratique, cette réponse est indépendante de l'épaisseur de la couche absorbante 18.

Pour déterminer exactement l'épaisseur de la couche 18 et celle de la couche 24 et les matériaux à utiliser pour ces couches ainsi que la planéité de la réponse spectrale dans le domaine considéré il convient de réaliser une simulation poussée du dispositif en prenant en compte la variabilité du coefficient d'absorption du matériau constitutif de la couche absorbante dans le domaine spectral considéré.

Une telle simulation sera considérée plus loin.

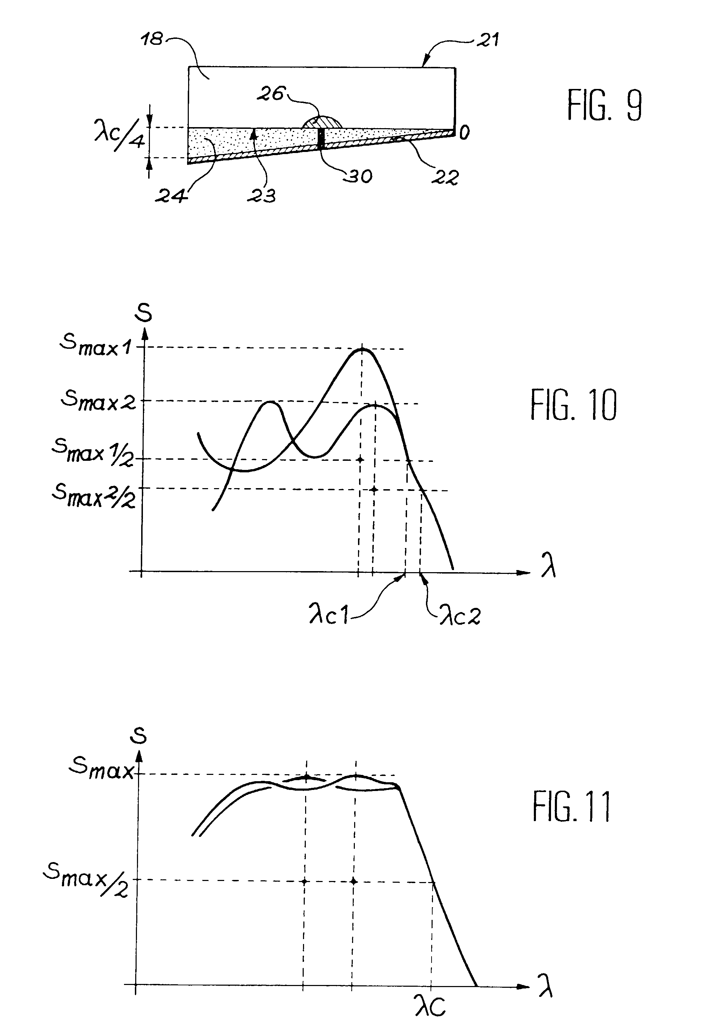

La figure 9 est une vue en coupe transversale schématique d'un autre mode de réalisation particulier du dispositif objet de l'invention.

On voit sur cette figure 9 un élément de détection qui diffère de celui de la figure 7 par la structure de la couche de déphasage 24.

Dans le cas de la figure 7, le déphasage apporté par la couche 24 est discret, cette couche 24 ayant une épaisseur constante mais ne recouvrant qu'une partie de la face-arrière 23 de la couche 18.

Au contraire, dans le cas de la figure 9, le déphasage apporté par la couche 24 est graduel. Cette couche 24 recouvre toute la face-arrière 23 de la couche 18 mais l'épaisseur de cette couche 24 augmente de manière linéaire d'une extrémité de cette face 23 de la couche 18 jusqu'à l'autre extrémité de cette face 23.

Plus précisément, le produit de cette épaisseur par l'indice de réfraction nd du matériau constitutif de cette couche de déphasage 24 varie, de manière linéaire, de 0 en une extrémité de la couche 24 jusqu'à la valeur $\lambda c/4$ en l'autre extrémité de cette couche phase 24.

Ce mode de réalisation particulier de la figure 9 peut permettre un meilleur amortissement des pics de la réponse spectrale que celui de la figure 7.

Dans le cas de la figure 9, il convient de former à travers les couches 24 et 22 une zone électriquement conductrice 30 qui est en contact avec la zone 26 de type N pour permettre la connexion de celle-ci à un dispositif extérieur lors de l'utilisation de l'élément de la figure 9.

Les avantages de la présente invention sont indiqués ci-après.

L'invention permet d'obtenir un dispositif de photodétection dont la réponse spectrale est sensiblement plate.

De plus cette réponse spectrale est la même pour tous les éléments de photodétection quelle que soit l'épaisseur de la couche absorbante servant à la détection.

L'invention permet une définition aisée de la longueur d'onde de coupure du dispositif.

Cette longueur d'onde de coupure est souvent définie comme la longueur d'onde correspondant à un signal dont l'amplitude est égale à la moitié de l'amplitude du pic de réponse.

Pour un dispositif de photodétection classique, l'amplitude de ce pic de réponse est très variable car elle est le résultat du produit de la réponse optique par la réponse électrique du dispositif de photodétection.

Ainsi la longueur d'onde de coupure est-elle fortement dépendante de l'épaisseur du matériau constitutif de la couche absorbante.

Le problème de cette variation de la longueur d'onde de coupure est schématiquement illustré par la figure 10.

Sur cette figure 10 on a représenté les variations de la réponse spectrale normalisée S en fonction de la longueur d'onde λ sans correction par une couche de déphasage.

On considère une épaisseur e1 de matériau absorbant et l'on note Smax1 la hauteur du pic correspondant.

On considère également une épaisseur e2 de ce matériau et l'on note Smax2 la hauteur du pic correspondant à cette épaisseur e2.

On a également noté sur la figure 10 les longueurs d'onde de coupure λc1 et λc2 correspondant respectivement aux épaisseurs e1 et e2.

La figure 11 montre les variations de la réponse spectrale normalisée S en fonction de la longueur d'onde λ dans le cas où l'on utilise une couche de déphasage sur la moitié de la surface de l'élément de photodétection comme cela est représenté sur les figures 6 et 7.

Dans le cas de la figure 11 on voit que les amplitudes Smax1 et Smax2 sont égales à une même valeur Smax et que les longueurs d'onde de coupure λc1 et λc2 sont égales à une même valeur λc.

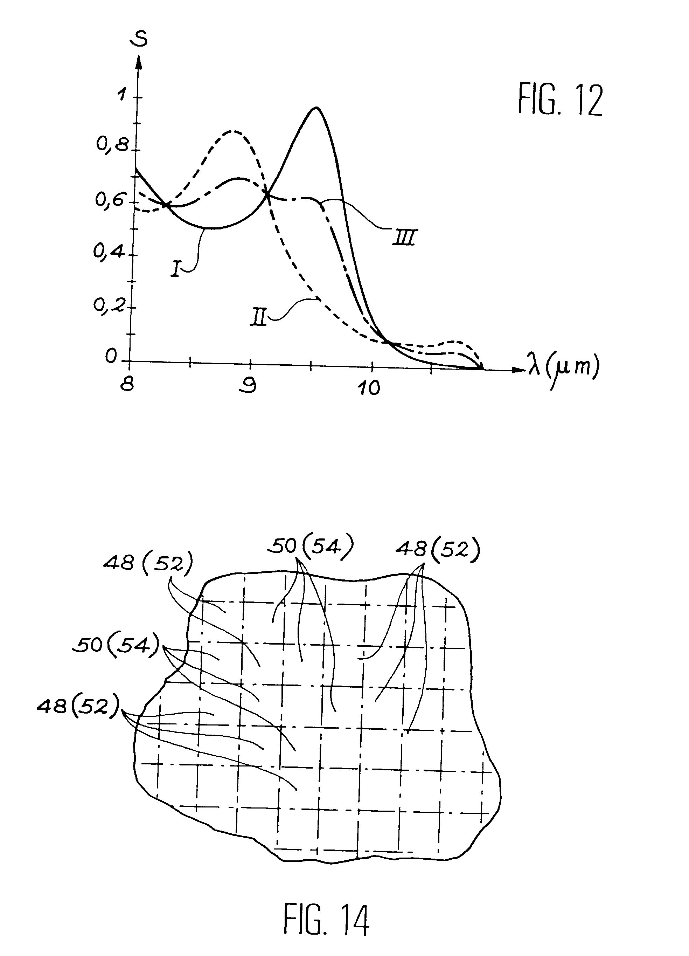

Un exemple réel de simulation est schématiquement illustré par la figure 12.

Sur cette figure 12, on a représenté les variations de la réponse spectrale normalisée S en fonction de la longueur d'onde λ exprimée en micromètres.

La courbe I de la figure 12 représente la réponse spectrale d'un élément de photodétection dont la couche absorbante a une épaisseur de 6 µm et qui n'est pas muni de couche de déphasage.

La courbe II représente la réponse spectrale du même élément de photodétection mais qui est muni en plus d'une couche de déphasage ayant une épaisseur de 1 µm et comprise entre la couche absorbante et la couche réflectrice de cet élément de photodétection.

La courbe III représente la réponse spectrale du même élément de photodétection mais comportant cette couche de déphasage de 1 µm d'épaisseur sur la moitié de sa surface (pour former un dispositif du genre de celui des figures 6 et 7).

Les figures 13A à 13D illustrent schématiquement diverses étapes d'un procédé de fabrication d'un dispositif de photodétection conforme à l'invention.

Ce dispositif comprend une pluralité d'éléments de photodétection ou pixels et l'on voit sur ces figures trois pixels adjacents 32, 34 et 36.

La structure de ce dispositif peut être matricielle.

Le procédé illustré par ces figures résulte en fait d'une modification du procédé classique permettant l'obtention d'un dispositif de photodétection muni d'une couche réflectrice mais pas d'une couche de déphasage.

On forme donc, sur un substrat 38 transparent dans le domaine de longueurs d'onde considéré, une couche absorbante ou couche détectrice 40 (figure 13A).

Le rayonnement que l'on veut détecter dans ce domaine de longueurs d'onde parvient à la couche 40 à travers le substrat 38.

Ensuite (figure 13B), on forme sur toute la surface de cette couche 40 une couche de déphasage 42 qui peut être faite du même matériau que la couche 40.

L'épaisseur ed de cette couche 42 est telle que le produit de ed par l'indice de réfraction du matériau constitutif de cette couche 42 soit égal au quart de la longueur d'onde centrale du domaine de longueurs d'onde considéré.

On grave ensuite cette couche de déphasage sur la moitié de la surface de chaque pixel au cours d'une étape de photolithographie (figure 13C).

Le procédé classique de fabrication du dispositif de photodétection est ensuite poursuivi.

En particulier

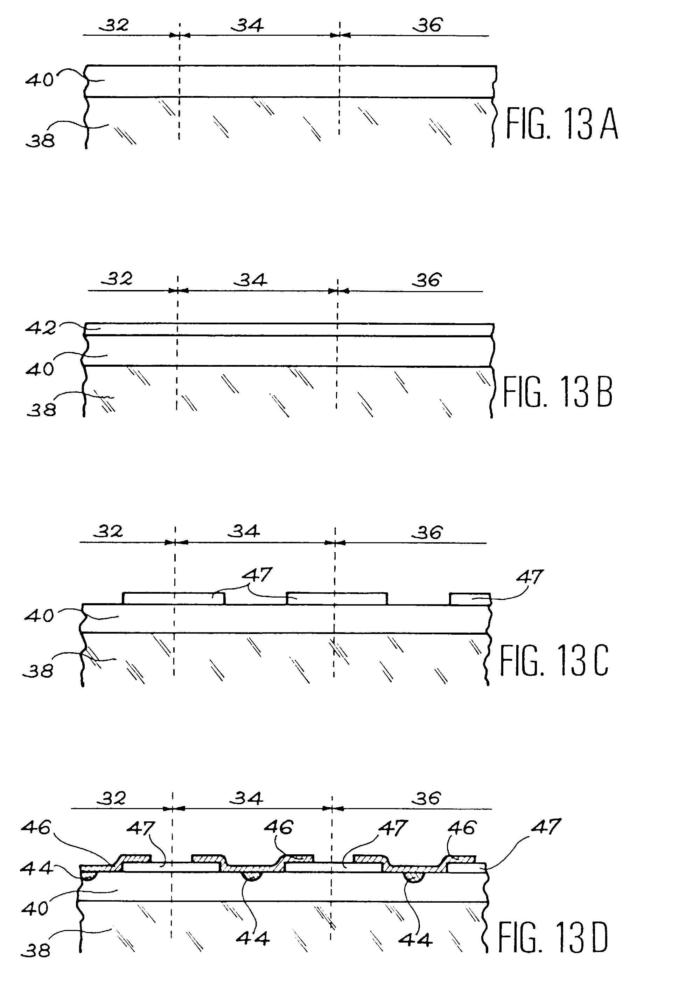

-    on forme (figure 13d) une zone 44 de type N dans chaque pixel (en supposant la couche 40 de type P)

-    on forme ensuite une couche réflectrice 46 sur les zones 47 de couche de déphasage obtenues par gravure et sur la face exposée de la couche absorbante, et

-    on enlève des parties de cette couche réflectrice 46 pour séparer les pixels les uns des autres.

Selon un autre mode de mise en oeuvre particulier non représenté, on grave simplement, au début de la fabrication, la couche absorbante elle-même sur une moitié de la surface de chaque pixel et sur une profondeur telle que le produit de cette profondeur par l'indice de réfraction du matériau constitutif de cette couche soit égal au quart de la longueur d'onde centrale du domaine spectral considéré.

L'application de la présente invention aux photodétecteurs à couches minces permet d'obtenir des détecteurs matriciels dont les performances sont améliorées par rapport aux détecteurs matriciels classiques (sans couche de déphasage).

La présente invention permet également d'obtenir un détecteur multispectral dont la structure est matricielle et qui comprend, comme le montre la vue de dessus de la figure 14, des éléments de photodétection 48 ne comportant pas de couche de déphasage et alternant avec d'autres éléments de photodétection 50 qui, conformément à la présente invention, comprennent une couche de déphasage.

L'extraction des signaux électriques des éléments de photodétection 48 et 50 permet de réaliser une détection multispectrale (détection de deux longueurs d'onde dans le cas de la figure 14).

En effet les deux catégories d'éléments de photodétection présentent des maximums à deux longueurs d'onde différentes et permettent une détection dans des gammes de longueurs d'onde différentes.

Un autre détecteur multispectral conforme à l'invention a également une structure matricielle et comprend un groupe d'éléments de photodétection 52 conformes à l'invention et un autre groupe d'autres éléments de photodétection 54 conformes à l'invention qui alternent avec les éléments 52 comme on le voit aussi sur la figure 14.

Les éléments 52 sont identiques.

De même, les éléments 54 sont identiques mais l'épaisseur de la couche de déphasage de ces éléments 54 est différente de l'épaisseur de la couche de déphasage des éléments 52.

Ces couches d'épaisseurs différentes créent des pics d'absorption multiples à des longueurs d'onde que l'on peut maîtriser.

Dans ce cas, il convient cependant de noter que l'épaisseur de la couche absorbante doit être parfaitement maîtrisée.

On utilise par exemple la technique de l'épitaxie par jet moléculaire pour former cette couche absorbante.

On peut alors envisager une détection tricolore (détection de trois longueurs d'onde au lieu de deux dans le cas de la figure 14, ce qui nécessite trois groupes d'éléments de photodétection correspondant à trois épaisseurs différentes pour la couche de déphasage).

Dans les exemples considérés plus haut, on a décrit des dispositifs de détection photovoltaïque conformes à l'invention, utilisant des couches absorbantes semiconductrices.

Cependant on peut également réaliser, conformément à l'invention, des dispositifs de photodétection par photoconduction utilisant des couches absorbantes photoconductrices.

La caractéristique essentielle de la présente invention est l'utilisation de la couche de déphasage qui peut être formée aussi bien sur une couche absorbante d'un dispositif photovoltaïque que sur une couche absorbante d'un dispositif de détection par photoconduction.

On précise que pour former un dispositif conforme à l'invention du genre de celui de la figure 9 il suffit de remplacer l'étape schématiquement illustrée par la figure 13C par une étape dans laquelle on grave la couche de déphasage 42 pour donner à celle-ci, dans chaque pixel, la forme qu'elle a sur la figure 9.

**Revendications**

1. Dispositif de photodétection comprenant au moins un élément de photodétection qui comprend :

   - une couche absorbante (18) apte à absorber une partie d'un rayonnement incident, tombant sur une première face de cette couche absorbante, et
   - une couche réflectrice (22) qui est placée en regard d'une deuxième face de cette couche absorbante et qui est apte à réfléchir une partie de ce rayonnement n'ayant pas été absorbée par la couche absorbante, cette couche absorbante créant un premier déphasage du rayonnement ainsi réfléchi par rapport au rayonnement incident,

   ce dispositif étant caractérisé en ce qu'il comprend en outre une couche de déphasage (24) qui est comprise entre la couche réflectrice et au moins une partie de la couche absorbante et qui est apte à créer un deuxième déphasage du rayonnement réfléchi par la couche réflectrice par rapport au rayonnement incident, l'épaisseur de la couche de déphasage étant choisie de façon que les premier et deuxième déphasages se compensent pour obtenir une réponse spectrale sensiblement plate de la part du dispositif dans un intervalle de longueurs d'onde déterminé.

2. Dispositif selon la revendication 1, dans lequel l'indice de réfraction du matériau constitutif de la couche de déphasage (24) est voisin de l'indice de réfraction du matériau constitutif de la couche absorbante (18).

3. Dispositif selon la revendication 2, dans lequel la couche absorbante (18) et la couche de déphasage (24) sont faites du même matériau.

4. Dispositif selon l'une quelconque des revendications 1 à 3, dans lequel le deuxième déphasage est discret et la couche de déphasage (24) recouvre la moitié de la deuxième face de la couche absorbante (18).

5. Dispositif selon la revendication 4, dans lequel la couche de déphasage (24) recouvre une partie périphérique de la deuxième face de la couche absorbante (24), la partie ainsi recouverte ayant la même aire que la partie non recouverte de cette deuxième face.

6. Dispositif selon l'une quelconque des revendications 1 à 3, dans lequel le deuxième déphasage est continu et graduel d'un côté à l'autre de la deuxième face de la couche absorbante (18).

7. Dispositif selon l'une quelconque des revendications 1 à 6, comprenant plusieurs exemplaires (48, 50, 52, 54) dudit élément de photodétection, organisés en matrice.

8. Dispositif selon l'une quelconque des revendications 1 à 6, comprenant plusieurs exemplaires (50) dudit élément de photodétection alternant avec d'autres éléments de photodétection (48) comprenant chacun seulement ladite couche absorbante et ladite couche réflectrice, de manière à former un détecteur multispectral.

9. Dispositif selon l'une quelconque des revendications 1 à 6, comprenant plusieurs exemplaires dudit élément de photodétection (52, 54) formant une pluralité de groupes d'éléments de photodétection, l'épaisseur de la couche de déphasage étant la même pour tous les éléments d'un même groupe mais différente d'un groupe à l'autre, de manière à former un détecteur multispectral.

10. Procédé de fabrication du dispositif de photodétection selon l'une quelconque des revendications 1 à 6, ce procédé étant caractérisé en ce qu'on forme d'abord la couche absorbante (40) et ensuite, pour chaque élément de photodétection (32, 34, 36), la couche de déphasage (47) puis la couche réflectrice (46).

11. Procédé selon la revendication 10, dans lequel une couche de déphasage (42) est formée sur la couche absorbante puis gravée pour chaque élément de photodétection.

12. Procédé selon la revendication 10, dans lequel, pour chaque élément de photodétection, la couche de déphasage est formée par gravure de la couche absorbante.

FIG. 1

FIG. 2

FIG. 3

FIG. 4

FIG. 5

FIG. 6

FIG. 7

FIG. 8

FIG. 9

FIG. 10

FIG. 11

FIG. 12

FIG. 14

32    34    36

40
38

FIG. 13 A

32    34    36

42
40
38

FIG. 13 B

32    34    36

47    47

40

38

FIG. 13 C

32    34    36

46    47    46    47    46    47

44

40

38    44    44

FIG. 13 D

**Office européen des brevets**

**RAPPORT DE RECHERCHE EUROPEENNE**

Numéro de la demande

EP 98 40 2972

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| A | EP 0 698 929 A (CANON KK) 28 février 1996 <br> * page 10, ligne 33 - ligne 49 * <br> --- | 1 | H01L31/0232 <br> H01L31/052 |
| A | PATENT ABSTRACTS OF JAPAN <br> vol. 097, no. 011, 28 novembre 1997 <br> & JP 09 186122 A (CANON INC), <br> 15 juillet 1997 <br> * abrégé * <br> --- | 1 | |
| A | PATENT ABSTRACTS OF JAPAN <br> vol. 008, no. 209 (E-268), <br> 22 septembre 1984 <br> & JP 59 094472 A (HANDOUTAI ENERUGII KENKYUSHO:KK), 31 mai 1984 <br> * abrégé * <br> --- | 1 | |
| A | EP 0 395 492 A (SOLEMS SA) 31 octobre 1990 <br> * le document en entier * <br> ----- | 1 | |

**DOMAINES TECHNIQUES RECHERCHES (Int.Cl.6)**

H01L

Le présent rapport a été établi pour toutes les revendications

| Lieu de la recherche | Date d'achèvement de la recherche | Examinateur |
|---|---|---|
| LA HAYE | 12 mars 1999 | Lina, F |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03 82 (P04C02)

15

**ANNEXE AU RAPPORT DE RECHERCHE EUROPEENNE
RELATIF A LA DEMANDE DE BREVET EUROPEEN NO.**                   EP 98 40 2972

La présente annexe indique les membres de la famille de brevets relatifs aux documents brevets cités dans le rapport de
recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

12-03-1999

| Document brevet cité au rapport de recherche | Date de publication | Membre(s) de la famille de brevet(s) | | Date de publication |
|---|---|---|---|---|
| EP 0698929 A | 28-02-1996 | JP | 8064849 A | 08-03-1996 |
| | | CN | 1125357 A | 26-06-1996 |
| | | US | 5620530 A | 15-04-1997 |
| EP 0395492 A | 31-10-1990 | FR | 2646560 A | 02-11-1990 |
| | | JP | 3062975 A | 19-03-1991 |
| | | US | 5039353 A | 13-08-1991 |

EPO FORM P0460